Europäisches Patentamt

European Patent Office

Office européen des brevets

(19)

(11) **EP 1 183 735 B1**

(12) **EUROPÄISCHE PATENTSCHRIFT**

(45) Veröffentlichungstag und Bekanntmachung des
Hinweises auf die Patenterteilung:
**19.10.2005 Patentblatt 2005/42**

(21) Anmeldenummer: **00947793.6**

(22) Anmeldetag: **06.06.2000**

(51) Int Cl.⁷: **H01L 29/51**, H01L 29/788

(86) Internationale Anmeldenummer:
**PCT/DE2000/001866**

(87) Internationale Veröffentlichungsnummer:
**WO 2000/075997 (14.12.2000 Gazette 2000/50)**

(54) **NICHTFLÜCHTIGE HALBLEITER-SPEICHERZELLE MIT EINEM METALLOXID-DIELEKTRIKUM UND VERFAHREN ZU DEREN HERSTELLUNG**

NON-VOLATILE SEMICONDUCTOR MEMORY CELL, COMPRISING A METAL-OXIDE DIELECTRIC AND A METHOD FOR PRODUCING THE SAME

CELLULE MEMOIRE A SEMI-CONDUCTEUR NON VOLATILE ET SON PROCEDE DE FABRICATION

(84) Benannte Vertragsstaaten:
**DE FR GB IT**

(30) Priorität: **08.06.1999 DE 19926108**

(43) Veröffentlichungstag der Anmeldung:
**06.03.2002 Patentblatt 2002/10**

(73) Patentinhaber: **Infineon Technologies AG**
**81669 München (DE)**

(72) Erfinder:
• **LUDWIG, Christoph**
**D-01465 Langebrück (DE)**
• **SCHREMS, Martin**
**A-8063 Hof-Bräbach (AT)**

(74) Vertreter: **Kindermann, Peter**
**Kindermann Patentanwälte**
**Postfach 100234**
**85593 Baldham (DE)**

(56) Entgegenhaltungen:
**US-A- 4 115 914**       **US-A- 5 739 566**
**US-A- 5 836 772**       **US-A- 5 998 264**

• **PATENT ABSTRACTS OF JAPAN vol. 1995, no. 08, 29. September 1995 (1995-09-29) & JP 07 135202 A (MIYAGI OKI DENKI KK;OTHERS: 01), 23. Mai 1995 (1995-05-23)**

**Beschreibung**

Die vorliegende Erfindung bezieht sich auf eine nichtflüchtige Halbleiter-Speicherzelle mit einem Metalloxid-Dielektrikum und ein Verfahren zu deren Herstellung und insbesondere auf EPROM, EEPROM und FLASH-EPROM-Speicherzellen.

Nichtflüchtige Halbleiter-Speicherzellen, wie sie beispielsweise aus der Druckschrift Kevin J. O'Coner et al., "A Novel CMOS Compatible Stacked Floating Gate usin TiN as a Control Gate", 1997 symposium on VLSI Technology Digest of Technical Papers, Seiten 61 -62 bekannt sind und in EPROM-, EEPROM- und FLASH-EPROM-Speichern verwendet werden, bestehen üblicherweise aus einem Halbleitersubstrat, einer isolierenden Tunneloxidschicht, einer leitenden Floating-Gate-Schicht, einer isolierenden dielektrischen Schicht und einer leitenden Steuer-Gate-Schicht. Zur Speicherung von Informationen werden Ladungen von einem im Halbleitersubstrat ausgebildeten Kanalbereich über die Tunneloxidschicht in die Floating-Gate-Schicht eingebracht. Verfahren zum Einbringen der Ladungen in die Floating-Gate-Schicht sind beispielsweise Injektion heißer Ladungsträger, Kanalinjektion und Fowler-Nordheim-Tunneln.

Ferner ist aus der Druckschrift Godberg, G.A.: "Novel dielectrics for non-volatile memory devices", Dissertation Univ. Warwick, Coventry UK, 1978, eine nichtflüchtige Halbleiter-speicherzelle bekannt, die ein Zweifach-Dielektrikum als Zwischenschicht aufweist und als dielektrische Schicht eine Metalloxidschicht, wie z.B. Titanoxid, Tantalpentoxid, Niobpentoxid und Zirkonpentoxid, enthält. Eine leitende Floating-Gate-Schicht wird hierbei jedoch nicht verwendet.

Zum Halten der in der Floating-Gate-Schicht gespeicherten Ladungen kommt insbesondere der zwischen Floating-Gate-Schicht und Steuer-Gate-Schicht liegenden dielektrischen Schicht eine besondere Bedeutung zu. Diese dielektrische Schicht besteht üblicherweise aus einer sogenannten "ONO"-Schicht, d. h. einer Schichtenfolge aus Oxid, Nitrid, Oxid. Vorzugsweise wird für diese ONO-Schicht eine Schichtenfolge von ca. 4 nm $SiO_2$, 7 nm $Si_3N_4$ und 4 nm $SiO_2$ verwendet.

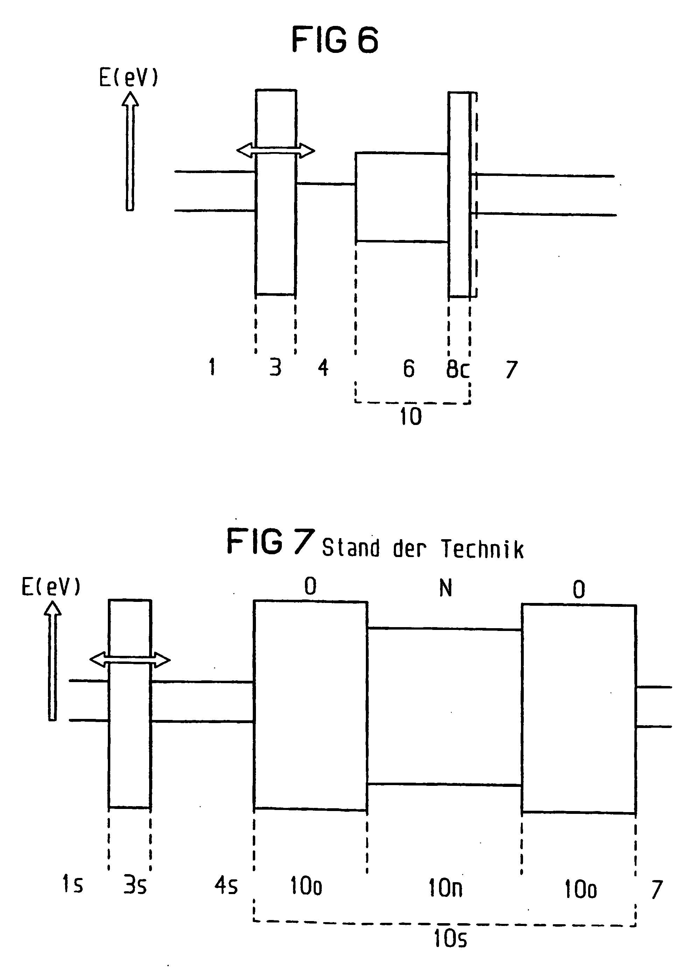

Aus der Druckschrift US 5,836,772 ist eine verbesserte ONO-Schicht bekannt, wobei die verwendete Nitridschicht dünner als die angrenzenden Oxidschichten ist. Die Figur 7 zeigt eine schematische Ansicht eines Bändermodells für eine herkömmliche nichtflüchtige Halbleiter-Speicherzelle mit einer ONO-Schichtfolge zwischen Floating-Gate-Schicht und Steuer-Gate-Schicht. In Figur 7 bezeichnet das Bezugszeichen 1s ein Halbleitersubstrat, 3s eine isolierende Tunneloxidschicht, 4s eine leitende Floating-Gate-Schicht, die vorzugsweise aus poly-Si besteht, 10s eine isolierende dielektrische Schicht und 7 eine leitende Steuer-Gate-Schicht, die wiederum aus poly-Si besteht. Die dielektrische Schicht 10s besteht aus einer $Si_3N_4$-Schicht 10n, die zwischen zwei $SiO_2$-Schichten 10o liegt und die sogenannte ONO-Schicht darstellt.

Nachteilig bei der Verwendung derartiger ONO-Schichten für die dielektrische Schicht 10s ist die relativ große Dicke von mindestens 15 nm. Diese Mindestdicke ist notwendig, um die benötigte Ladungshaltung in der Floating-Gate-Schicht 4s zu gewährleisten, wodurch eine Hochintegration erschwert wird. Eine derartige Mindestdicke von ca. 15 nm wirkt sich ferner negativ auf den sogenannten Koppelfaktor in der nichtflüchtigen Halbleiter-Speicherzelle aus, der maßgeblich sowohl die Leseströme (und damit die Zugriffszeiten) als auch die Größe der Spannungen bestimmt, die zum Löschen und Beschreiben der Halbleiter-Speicherzellen notwendig sind. Eine Verbesserung des Koppelfaktors läßt sich somit nur durch eine Vergrößerung der Floatig-Gate-Bereiche erzielen,was sich wiederum negativ auf die Integrationsdichte derartiger Halbleiter-Speicherzellen auswirkt.

Aus der gattungsbildenden Druckschrift US 4,115,914 ist eine nichtflüchtige Halbleiter-Speicherzelle mit einem Halbleitersubstrat, einer isolierenden Tunneloxidschicht, einer leitenden Floating-Gate-Schicht, einer isolierenden dielektrischen Schicht, und einer leitenden Steuer-Gate-Schicht bekannt, wobei die dielektrische Schicht zumindest eine Metalloxidschicht mit, beispielsweise $TiO_2$ aufweist.

Ferner ist aus der Druckschrift JP 07 135202 eine Halbleitervorrichtung und ein dazugehöriges Herstellungsverfahren bekannt, wobei zum Einebnen einer Zwischenisolierschicht eine Wolframschicht als, dielektrische Schicht abgeschieden und anschließend zum Ausbilden einer $WO_3$-Schicht oxidiert wird.

Aus der nachveröffentlichten Druckschrift US 5,998,264 ist ferner eine Flash-Speicherzelle sowie ein dazugehöriges Herstellungsverfahren bekannt, wobei für die dielektrische Schicht zwischen Floating-Gate und Steuerelektrode ein Dielektrikum wie z.B. $TiO_2$ und für die Floating-Gateschicht ein Dielektrikum mit hoher Dielektrizitätskonstante wie z.B. WN oder TiN verwendet wird.

Der Erfindung liegt daher die Aufgabe zugrunde, eine nichtflüchtige Halbleiter-Speicherzelle und ein Verfahren zu deren Herstellung zu schaffen, bei der sowohl eine verbesserte Integrationsdichte als auch eine Verringerung der notwendigen Steuerspannungen möglich ist.

Diese Aufgabe wird hinsichtlich der Halbleiter-Speicherzelle durch die Merkmale des Patentanspruchs 1 und hinsichtlich des Verfahrens durch die Maßnahmen des Patentanspruchs 6 gelöst.

Insbesondere durch die Verwendung einer $Si_3N_4$-Schicht, die die Metalloxidschicht einschließt, können Leckströme weiter reduziert und eine höhere Integrationsdichte realisiert werden.

In den Unteransprüchen sind vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:

Figuren 1a) bis 1f) perspektivische Ansichten der Verfahrensschritte zur Herstellung einer Halbleiter-Speicherzelle gemäß einem nicht beanspruchten ersten Ausführungsbeispiel;

Figur 2 eine schematische Ansicht eines Bändermodells der Halbleiter-Speicherzelle gemäß dem nicht beanspruchten ersten Ausführungsbeispiel;

Figur 3 eine schematische Ansicht eines Bändermodells der Halbleiter-Speicherzelle gemäß einem nicht beanspruchten zweiten Ausführungsbeispiel;

Figur 4 eine schematische Ansicht eines Bändermodells der Halbleiter-Speicherzelle gemäß einem nicht beanspruchten dritten Ausführungsbeispiel;

Figur 5 eine schematische Ansicht eines Bändermodells der erfindungsgemäß Halbleiter-Speicherzelle;

Figur 6 eine schematische Ansicht eines Bändermodells der Halbleiter-Speicherzelle gemäß einem nicht beanspruchten vierten Ausführungsbeispiel; und

Figur 7 eine schematische Ansicht eines Bändermodells der Halbleiter-Speicherzelle gemäß dem Stand der Technik.

Die Figuren 1a) bis 1f) zeigen perspektivische Ansichten zur Veranschaulichung der Verfahrensschritte für die Herstellung einer Halbleiter-Speicherzelle gemäß einem nicht beanspruchten ersten Ausführungsbeispiel.

Im Verfahrensschritt gemäß Figur 1a) wird zunächst in einem Halbleitersubstrat 1 eine flache Grabenisolation 2 (shallow trench isolation, STI-Prozeß) zur Ausbildung von aktiven Bereichen durchgeführt. Vorzugsweise besteht das Halbleitersubstrat 1 aus Si, SiGe, SiC, SOI, GaAs oder einem sonstigen III-V-Halbleiter. Die durch den STI-Prozeß freigelegten Gräben werden anschließend mit einem TEOS-$SiO_2$ aufgefüllt und planarisiert. Auf der planarisierten Fläche wird anschließend eine isolierende Tunneloxidschicht 3, eine leitende Floating-Gate-Schicht 4 und eine metallische Schicht 5 nacheinander abgeschieden. Vorzugsweise besteht die Tunneloxidschicht 3 aus $SiO_2$, die Floating-Gate-Schicht 4 aus TiN und die metallische Schicht 5 aus Ti. Das Abscheiden der Floating-Gate-Schicht 4 und der metallischen Schicht 5 wird vorzugsweise in einem Sputter-Verfahren durchgeführt, wobei in einer Gasatmosphäre von $N_2$ zunächst Ti zum Ausbilden der TiN-Schicht aufgebracht und anschließend zum Ausbilden der Ti-Schicht die $N_2$-Zufuhr abgeschaltet wird, so daß nur noch Argon in der Sputterkammer vorhanden ist. Der in Figur 1a) gezeigte Schichtstapel läßt sich somit auf besonders einfache Weise erzeugen.

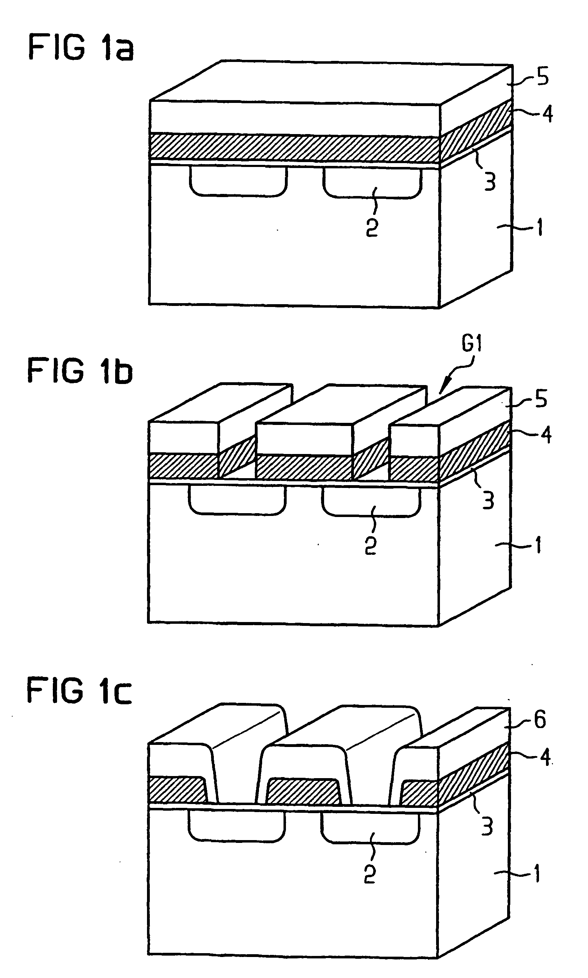

In einem Verfahrensschritt gemäß Figur 1b) wird anschließend ein Ätzen der metallischen Schicht 5 und der Floating-Gate-Schicht 4 bis zur Tunneloxidschicht 3 durchgeführt, wobei Floating-Gate-Bahnen ausgebildet werden. Vorzugsweise wird durch Gräben G1 für dieses Ätzen ein anisotropes Plasmaätzen mit $BCl_3$ oder $CF_4$ verwendet. Gemäß Figur 1b) befinden sich die derart freigeätzten Gräben G1 über der im Halbleitersubstrat ausgebildeten TEOS $SiO_2$-Schicht 2.

In einem nachfolgenden Verfahrensschritt wird gemäß Figur 1c) eine Oxidation der metallischen Schicht 5 durchgeführt. Bei Verwendung einer Ti-Schicht wird beispielsweise im Sauerstoffplasma bei ca. 200 °C bis 300 °C oder im RTP-Ofen bei 700 °C die metallische Schicht 5 vollständig in eine Metalloxidschicht 6 umgewandelt, wobei teilweise auch die freigelegten Seitenbereiche der Floating-Gate-Schicht 4 oxidiert werden. Je nach gewählter Prozeßvariante oxidiert somit auch die TiN-Schicht, so daß die Floating-Gate-Schicht (TiN-Schicht) 4 nach diesem Oxidationsschritt oben und seitlich von der Metalloxidschicht 6 ($TiO_2$) umgeben ist. Bei Verwendung von TiN für die Floating-Gate-Schicht 4 und Ti für die metallische Schicht 5 ist die metallisch leitende TiN-Schicht nach der Oxidation vollständig isoliert.

Figur 1d) zeigt eine perspektivische Ansicht der Halbleiter-Speicherzelle gemäß dem ersten nicht beanspruchten Ausführungsbeispiel nach einem Abscheiden einer Steuer-Gate-Schicht 7. Vorzugsweise wird als Steuer-Gate-Schicht 7 poly-Si mit einem Gasgemisch aus Silan und $H_2$ bei 620 °C ganzflächig abgeschieden.

Gemäß Figur 1e) wird in einem weiteren Verfahrensschritt zum Ausbilden von zweiten Gräben G2 ein weiteres Ätzen der Steuer-Gate-Schicht 7, der Metalloxidschicht 6 und der Floating-Gate-Schicht 4 zur Ausbildung von Steuer-Gate-Bahnen durchgeführt. Vorzugsweise handelt es sich hierbei um eine anisotrope reaktive Ionenätzung (RIE), wobei eine nicht dargestellte Oxid-Hartmaske verwendet wird. Eine derartige Oxid-Hartmaske besitzt vorzugsweise eine Dicke von 100 nm und kann durch ein TEOS-Abscheideverfahren unter Verwendung von Si ($C_2H_5O_4$) ausgebildet werden. Diese Oxid-Hartmaske wird z. B. durch $CHF_3$, durch $CF_4$ oder durch ein Gemisch aus $CHF_3$ und $CF_4$ anisotrop geätzt. Das eigentliche Ätzen zum Ausbilden der zweiten Gräben G2 wird hinsichtlich des poly-Si für die Steuer-Gate-Schicht 7 mit $Cl_2$ oder HBr oder einer Mischung dieser beiden Gase durchgeführt, wobei He und $O_2$ zugesetzt werden kann. Es handelt sich hierbei um ein anisotropes Ätzen. Für das Ätzen der Metalloxidschicht 6 wird bei Verwendung von $TiO_2$ beispielsweise ein Mischgas aus $CF_4$ und $O_2$ verwendet, wobei die Temperatur bei ca. 250 °C liegt. Das Mischgas wird durch eine HF-Einkopplung oder eine Mikrowellenanregung zur Bildung eines Plasmas angeregt. Vorzugsweise beträgt das Verhältnis von $CF_4$ zu $O_2$ etwa 2 % bis 98 %.

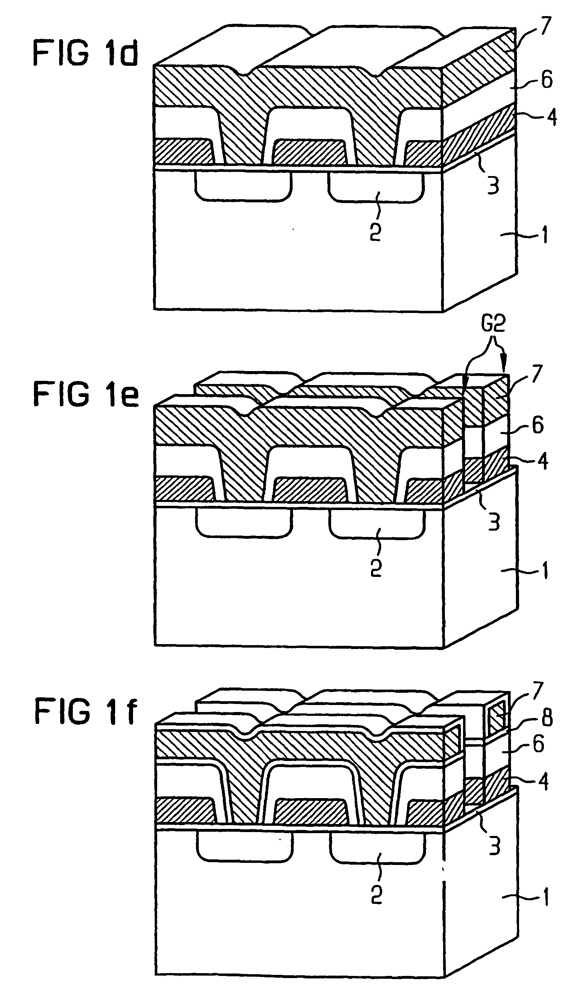

Für die Ätzung der Metalloxidschicht 6 selbst ist das freiwerdende Fluor und die damit verbundene Reaktion des Metalloxids ($TiO_2$) mit dem Fluor verantwortlich. Es bilden sich flüchtige Metall-Fluor-Verbindungen, wobei der Sauersoff die Aufgabe als Passivator für das eventuell vorhandene poly-Silizium übernimmt. Durch Sauerstoff bildet sich $SiO_2$, dessen Bindungsenergie (ohne den Einsatz von zusätzlicher Ionenenrgie) zu hoch ist, um durch den geringen Fluoranteil signifikant geätzt zu werden. Die Ätzung der Metalloxidschicht 6 erfolgt daher sehr selektiv zur Steuer-Gate-Schicht 7 (poly-Silizium). Gemäß Figur 1f) wird dadurch eine die Steuer-Gate-Schicht 7 umgebende $SiO_2$-Schicht erzeugt.

Das Ätzen der Floating-Gate-Schicht 4 wird mit $BCl_3$ oder mit dem vorstehend beschriebenen Ätzverfahren geätzt.

Die für das vorstehend beschriebene Ätzen notwendige Oxid-Hartmaske (nicht dargestellt) wird in einem nachfolgenden Spacer-Ätzprozeß entfernt.

Nach der Implantation der Source- und Drain-Gebiete in den Gräben G2 wird in einem weiteren Verfahrensschritt gemäß Figur 1f) ein RTP-Ausheilen durchgeführt. Dieser RTP-Ausheilprozeß dient insbesondere der Aktivierung der Donatoren/Akzeptoren und dem Ausheilen von Ätzschäden. Ferner wird bei Verwendung von $TiO_2$ für die Metalloxidschicht 6 und poly-Si für die Steuer-Gate-Schicht 7 eine $SiO_2$-Zwischenschicht 8 an der Grenzfläche ausgebildet, die sich vorteilhaft für das Halten von Ladungen in der Floating-Gate-Schicht 4 auswirkt. Die Metalloxidschicht 6 und die $SiO_2$-Zwischenschicht 8 bilden gemeinsam eine dielektrische Schicht 10.

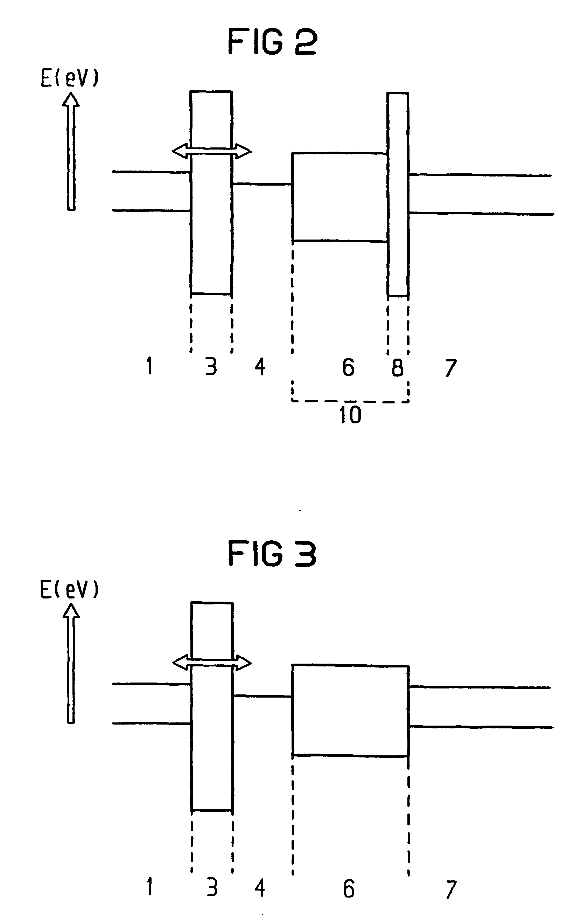

Die Figur 2 zeigt eine schematische Ansicht eines Bändermodells der Halbleiter-Speicherzelle gemäß dem nicht beanspruchten ersten Ausführungsbeispiel. Gleiche Bezugszeichen bezeichnen hierbei gleiche Schichten wie in den Figuren 1a) bis 1f), weshalb auf eine weitere Beschreibung verzichtet wird.

Gemäß Figur 2 besitzt das Silizium-Halbleitersubstrat 1 sowie die aus poly-Silizium bestehende Steuer-Gate-Schicht 7 einen Bandabstand von ca. 1,1 eV. Demgegenüber besitzt das als Tunneloxidschicht 3 verwendete $SiO_2$ einen relativ hohen Bandabstand von ca. 8 eV. Ein Schreiben, Lesen und Löschen von Ladungsinformationen in die Floating-Gate-Schicht 4 findet insbesondere über ein mit einem Doppelpfeil (<->) gekennzeichnetes Tunneln durch die Tunneloxidschicht 3 statt. Gemäß Figur 2 besteht die Floating-Gate-Schicht 4 aus einer dünnen metallisch leitenden TiN-Schicht mit einer Dicke von ca. 5 nm bis 50 nm. Die dielektrische Schicht 10 besteht aus der $SiO_2$-Zwischenschicht 8 und einer Metalloxidschicht 6 aus $WO_x$ und/oder $TiO_2$. Im Gegensatz zur ONO-Schicht beträgt die Dicke dieser dielektrischen Schicht typischerweise 25 nm, jedoch maximal 50 nm. Auf diese Weise erhält man eine geringe Stapeldicke für die nichtflüchtige Halbleiter-Speicherzelle, was ein Vorteil für weitere Shrink-Generationen ist und insbesondere einen Vorteil für die Integration von sogenannten embeddedflash-Prozessen darstellt.

Aufgrund der außerordentlich hohen Dielektrizitätskonstante von $WO_x$ und $TiO_2$ und der relativ geringen Dicke für die dielektrische Schicht 10 erhält man ferner somit einen sehr günstigen kapazitiven Koppelfaktor, der sich aus dem kapazitiven Verhältnis der Kapazität $C_{FG-CG}$ zu ($C_{FG-CG}$ + $C_{FG-Substrat}$) ergibt, wobei $C_{FG-CG}$ die Kapazität zwischen der Floating-Gate-Schicht 4 und der Steuer-Gate-Schicht 7 und $C_{FG-Substrat}$ die Kapazität zwischen der Floating-Gate-Schicht 4 und den darunterliegenden Source-, Drain- und Kanalgebieten liegen.

Durch Ersetzen der herkömmlichen ONO-Schicht durch die erfindungsgemäße dielektrische Schicht aus $WO_x$ und/oder $TiO_2$ mit geringer Dicke erhöht sich somit der Koppelfaktor von 0,7 bei einer herkömmlichen Halbleiter-Speicherzelle auf ca. 0,9 bis 0,95 bei der erfindungsgemäßen Halbleiter-Speicherzelle. Dadurch läßt sich die Halbleiter-Speicherzelle mit geringeren Steuerspannungen und/oder innerhalb kürzerer Zeiten beschreiben und löschen. Kürzere Lese- bzw. Schreibzeiten sind insbesondere beim Einsatz in späteren Endgeräten als sogenannte "Smart Cards" von Bedeutung. Andererseits schlagen sich die niedrigeren Steuerspannungen in einem geringeren Platzbedarf auf dem Chip nieder, da die Funktionselemente (Hochvolt-Transistoren), welche beispielsweise die Programmier- und Löschspannungen in einem nichtflüchtigen Speicherchip generieren und schalten, kleiner dimensioniert werden können (Kleinere Spannungen erlauben in der Regel kleinere Abmessungen für die isolierenden Bereiche).

Ein weiterer Vorteil des größeren Koppelfaktors besteht darin, daß die Stromergiebigkeit der Halbleiter-Speicherzellen vergrößert ist. Eine ausreichende Stromergiebigkeit ist die zwingende Voraussetzung für einen schnellen Lesezugriff vor allem bei kleinen Versorgungsspannungen. Insbesondere bei der Verwendung von Halbleiter-Speicherzellen in kontaktlosen Chipkarten werden Versorgungsspannungen bis zu 2 V und darunter gefordert.

Figur 3 zeigt eine schematische Ansicht eines Bändermodells der Halbleiter-Speicherzelle gemäß einem nicht beanspruchten zweiten Ausführungsbeispiel. Gleiche Bezugszeichen bezeichnen gleiche oder ähnliche Schichten, weshalb auf ihre Beschreibung nachfolgend verzichtet wird.

Im Gegensatz zur nichtflüchtigen Halbleiter-Speicherzelle gemäß dem nicht beanspruchten ersten Ausführungsbeispiel besitzt die Halbleiter-Speicherzelle gemäß Figur 3 keine $SiO_2$-Zwischenschicht 8, wodurch sich das Herstellungsverfahren weiter vereinfachen läßt. Aufgrund der äußerst günstigen Eigenschaften der aus $WO_x$ und/oder $TiO_2$ bestehenden Metallo-

xidschicht 6 hinsichtlich Ladungshaltung der in der Floating-Gate-Schicht 4 gehaltenen Ladungen ergibt sich eine weitere Verbesserung des Koppelfaktors bei geringfügiger Verschlechterung der Tunnelbarriere.

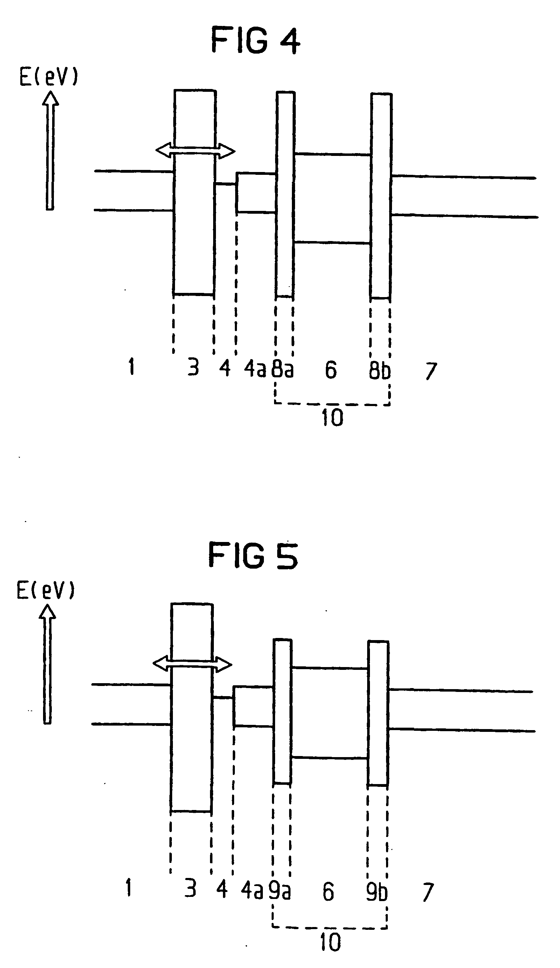

Figur 4 zeigt eine schematische Ansicht eines Bändermodells der Halbleiter-Speicherzelle gemäß einem nicht beanspruchten dritten Ausführungsbeispiel. Gleiche Bezugszeichen bezeichnen gleiche oder ähnliche Schichten,weshalb auf ihre Beschreibung nachfolgend verzichtet wird.

Im Gegensatz zur Halbleiter-Speicherzelle gemäß Figuren 2 und 3 besitzt die Halbleiter-Speicherzelle gemäß Figur 4 eine Doppelschicht bestehend aus metallischen TiN 4 und poly-Silizium 4a für die Floating-Gate-Schicht (ladungsspeichernde Schicht). Die Verwendung einer derartigen ladungsspeichernden Doppelschicht hat den Vorteil, daß beim Ausheilschritt gemäß Figur 1f) nicht nur eine $SiO_2$-Zwischenschicht 8b an der Grenzschicht zur Steuer-Gate-Schicht 7 sondern auch eine weitere $SiO_2$-Schicht 8a zur Polysilizium-Schicht 4a der Floating-Gate-Schicht automatisch aufgrund der Ausdiffusion von Sauerstoff aus der Metalloxidschicht 6 ausgebildet wird. Auf diese Weise erhält man ohne nennenswerte Veränderung der Verfahrensschritte eine äußerst ladungsdichte dielektrische Schicht 10, wobei Ladungsverluste durch Tunnel- oder Leckströme weiter verbessert sind. In ähnlicher Weise wie in den vorstehend beschriebenen Ausführungsbeispielen kann die Metalloxidschicht 6 wiederum aus $WO_x$ und/oder $TiO_2$ bestehen.

Figur 5 zeigt eine schematische Ansicht eines Bändermodells der Halbleiter Speicherzelle gemäß einem Ausführungsbeispiel der vorliegenden Erfindung. Gleiche Bezugszeichen bezeichnen gleiche oder ähnliche Schichten, weshalb auf ihre Beschreibung nachstehend verzichtet wird.

Im Gegensatz zum nicht beanspruchten dritten Ausführungsbeispiel besteht die erfindungsgemäß Halbleiter-Speicherzelle aus der dielektrischen Schicht 10, die neben der Metalloxidschicht 6 aus $WO_x$ und/oder $TiO_2$ jeweils eine Nitridschicht 9a und 9b aus $Si_3N_4$. Der Bandabstand von $Si_3N_4$ ist zwar gegenüber $SiO_2$ geringer (ca. 5 eV), stellt jedoch eine Alternative zu den in Figur 4 dargestellten $SiO_2$-Schichten 8a und 8b dar. Insbesondere beim Anlegen von Steuerspannungen zum Schreiben, Lesen und/oder Löschen von Ladungen aus der Floating-Gate-Schicht 4 und 4a besitzen diese $Si_3N_4$-Schichten 9a und 9b Vorteile hinsichtlich eventuell auftretender Leckströme.

Figur 6 zeigt eine schematische Ansicht eines Bändermodells der Halbleiter-Speicherzelle gemäß einem nicht beanspruchten vierten Ausführungsbeispiel. Gleiche Bezugszeichen bezeichnen wiederum gleiche oder ähnliche Schichten, weshalb auf ihre Beschreibung nachfolgend verzichtet wird.

Die Halbleiter-Speicherzelle gemäß dem nicht beanspruchten vierten Ausführungsbeispiel entspricht hierbei im wesentlichen der Halbleiter-Speicherzelle gemäß Figur 2, wobei jedoch die $SiO_2$-Schicht 8 durch eine nitridierte $SiO_2$-Schicht 8c ersetzt wird. Eine derartige nitridierte $SiO_2$-Schicht 8c läßt sich beispielsweise durch Abscheiden einer Siliziumdioxidschicht oder durch eine thermische Oxidation erzeugen. Wird diese Abscheidung bzw. thermische Oxidation in einer Atmosphäre durchgeführt, die zusätzlich NO- bzw. $N_2O$-Moleküle enthält, so läßt sich die nitridierte $SiO_2$-Schicht 8c herstellen. Eine derartige nitridierte $SiO_2$-Schicht verhindert zusätzlich Leckströme und verbessert dadurch das ladungsspeichernde Verhalten der erfindungsgemäßen Halbleiter-Speicherzelle.

Nachfolgend wird die Herstellung der aus $WO_x$ und/oder $TiO_2$ bestehenden Metalloxidschicht 6 mit seiner außerordentlich hohen relativen Dielektrizitätskonstante $\varepsilon_r$ beschrieben.

Die für den Koppelfaktor wichtige relative Dielektrizitätskonstante wird demzufolge bei Verwendung von $TiO_2$ als Metalloxidschicht 6 durch eine Temperung bei ca. 900 °C in der sogenannten Rutile-Phase erzeugt. Diese Temperung kann bereits bei der Erzeugung der Titandioxidschicht ($TiO_2$) erfolgen oder aber erst in einem späteren Prozeßschritt in der Herstellung einer integrierten Schaltung durchgeführt werden.

Zum Ausbilden der $WO_x$-Schicht als Metalloxidschicht 6 in der erfindungsgemäßen Halbleiter-Speicherzelle kann beispielsweise eine wolframhaltige Schicht, eine reine Wolframschicht, eine Wolframnitrid- oder eine Wolframsilizidschicht aufgebracht werden, die mit einem herkömmlichen Sputter-Prozeß oder CVD-Verfahren erzeugt wird. Nach Abscheiden der wolframhaltigen Schicht wird diese in gleicher Weise wie in Figur 1c) die Ti-Schicht 5 in eine Metalloxidschicht 6, d. h. Wolframoxidschicht, umgewandelt. Die Umwandlung findet in einer Sauerstoffatmosphäre (z. B. $O_2$ oder $H_2O$) bei einer Temperatur von 500 °C bis 1200 °C statt. Bei der Verwendung einer reinen Wolframschicht oder der Verwendung einer Wolframsilizidschicht sollte die Temperatur etwa 600 °C nicht übersteigen oder eine so genannte "low thermal budget" RTO ("rapid thermal oxidation") durchgeführt werden. Dadurch wird verhindert, daß beispielsweise Silizium in die wolframhaltige Schicht eindiffundiert und eine Oxidation der wolframhaltigen Schicht verhindert wird.

Die thermische Oxidation der wolframhaltigen Schicht führt zu einer Wolframoxidschicht, die kaum Verunreinigungen und die eine relative Dielektrizitätskonstante $\varepsilon_r$ größer als 50 aufweist. Die Schichten und Prozeßparameter werden dabei so gewählt, daß die wolframhaltige Schicht vollständig in die Wolframoxidschicht umgewandelt wird.

Durch eine nachfolgende Wärmebehandlung bei einer Temperatur von etwa 550 °C bis 1100 °C in einer inerten Atmosphäre läßt sich eine Wolframoxidschicht ($WO_x$ mit x = 2 bis 3) in einer kristallinen oder gesinterten Phase (z. B. Phasen mit einer orthorhombischen oder tetragonalen Symmetrie) erzeugen. Diese Wärmebehandlung kann bereits direkt im Anschluß an die Erzeugung der Wolframoxidschicht ($WO_x$) erfolgen oder aber erst in einem späteren Prozeßschritt bei der Herstellung einer integrierten Schaltung durchgeführt werden.

Alternativ kann die Wolframoxidschicht auch direkt aufgebracht werden, wobei das Abscheiden der wolframhaltigen Schicht sowie die termische Oxidation dieser Schicht entfällt. Die Wolframoxidschicht wird hierbei durch ein CVD-Verfahren erzeugt. Dazu werden Wolframfluorid und Wasser in gasförmigen Zustand als Precusoren auf die Substratoberfläche geführt:

$$2WF_6 + 4 H_2O \rightarrow (WOF_4) + WO_3 + (HF) \text{ oder}$$

$$WF_6 + H_2O + Si \rightarrow W - O + (2HF) + (SiF_4).$$

Dies führt zur Abscheidung einer ca. 2 bis 20 nm dicken Wolframoxidschicht.

Durch eine nachfolgende Wärmebehandlung bei einer Temperatur von ca. 550 bis 1100 °C wird anschließend in gleicher Weise wie vorstehend beschrieben die Wolframoxidschicht ($WO_x$ mit x = 2 bis 3) in einer kristallinen oder gesinterten Phase (z. B. orthorhombische oder tetragonale Symmetrie) erzeugt.

Insbesondere durch die hohe Temperaturstabilität des $WO_x$ läßt sich dieses Material besonders einfach in das Verfahren gemäß Figuren 1a) bis 1f) integrieren.

## Patentansprüche

1. Nichtflüchtige Halbleiter-Speicherzelle mit:

   einem Halbleitersubstrat (1);
   einer isolierenden Tunneloxidschicht (3);
   einer leitenden Floating-Gate-Schicht (4);
   einer isolierenden dielektrischen Schicht (10); und
   einer leitenden Steuer-Gate-Schicht (7), wobei die dielektrische Schicht (10) zumindest eine $Si_3N_4$-Schicht (9a, 9b) und eine Metalloxidschicht (6) aus $TiO_2$ aufweist,

   **dadurch gekennzeichnet, daß**
   die $Si_3N_4$-Schicht (9a, 9b) die Metalloxidschicht (6) aus $WO_x$, mit x = 2 bis 3, und/oder $TiO_2$ einschließt.

2. Nichtflüchtige Halbleiter-Speicherzelle nach Patentanspruch 1,
   **dadurch gekennzeichnet, daß** die Floating-Gate-Schicht eine Poly-Si-Schicht (4a) aufweist.

3. Nichtflüchtige Hälbleiter-Speicherzelle nach Patentanspruch 1 oder 2,
   **dadurch gekennzeichnet, daß** die Floating-Gate-Schicht eine TiN-Schicht oder WN-Schicht (4) aufweist.

4. Nichtflüchtige Halbleiter-Speicherzelle nach einem der Patentansprüche 1 bis 3,
   **dadurch gekennzeichnet, daß** die Schichtdicke der dielektrischen Schicht (10) größer als 15 nm ist.

5. Nichtflüchtige Halbleiter-Speicherzelle nach einem der Patentansprüche 1 bis 4,
   **dadurch gekennzeichnet, daß** die Schichtdicke der Floating-Gate-Schicht (4, 4a) in einem Bereich von 5 nm bis 50 nm liegt.

6. Verfahren zur Herstellung einer nichtflüchtigen Halbleiter-Speicherzelle nach einem der Patentansprüche 1 bis 5 mit den Schritten

   a) Ausbilden von aktiven Bereichen in einem Halbleitersubstrat (1);
   b) Ausbilden einer Tunneloxidschicht (3);
   c) Abscheiden einer Floating-Gate-Schicht (4);
   d) Abscheiden einer metalhaltigen Schicht (5), die ein Metall oder eine Metallverbindung enthält1;
   e) Ätzen der metalhaltigen Schicht (5) und der Floating-Gate-Schicht (4);
   f) Oxidieren der metalhaltigen Schicht (5) und freigelegter Seitenbereiche der Floating-Gate-Schicht (4) zur Ausbildung einer dielektrischen Schicht (6);
   g) Abscheiden einer Steuer-Gate-Schicht (7); und
   h) Ätzen der Steuer-Gate-Schicht (7), der dielektrischen Schicht (6) und der Floating-Gate-Schicht (4).

7. Verfahren nach Patentanspruch 6,
   **gekennzeichnet durch** die weiteren Schritte

   i) Ausbilden einer isolierenden Zwischenschicht (8) an der Oberfläche der Steuer-Gate-Schicht (7).

8. Verfahren nach einem der Patentansprüche 6 oder 7,
   **dadurch gekennzeichnet, daß** in Schritt c) eine TiN-Schicht und in Schritt d) eine Ti-Schicht abgeschieden wird.

9. Verfahren nach einem der Patentansprüche 6 oder 7,
   **dadurch gekennzeichnet, daß** in Schritt c) eine poly-Si-Schicht und in Schritt d) eine $WO_x$-Schicht mit x = 2 bis 3 abgeschieden wird.

10. Verfahren nach einem der Patentansprüche 6 oder 7,

**dadurch gekennzeichnet, daß** in den Schritten c) und d) eine gemeinsame wolframhaltige Schicht abgeschieden wird und in Schritt f) das Oxidieren solange durchgeführt wird, bis eine oxidierte Teilschicht der wolframhaltigen-Schicht die dielektrische Schicht (6) und eine nicht oxidierte Teilschicht der wolframhaltigen Schicht die Floating-Gate-Schicht (4) darstellt.

**Claims**

1. Non-volatile semiconductor memory cell, having:

   a semiconductor substrate (1);
   an insulating tunnel oxide layer (3);
   a conductive floating-gate layer (4);
   an insulating dielectric layer (10); and
   a conductive control-gate layer (7),
   the dielectric layer (10) having at least one $Si_3N_4$ layer (9a, 9b) and a metal oxide layer (6) of $TiO_2$,

   **characterized in that**
   the $Si_3N_4$ layer (9a, 9b) encloses the metal oxide layer (6) of $WO_x$, where x = 2 to 3, and/or $TiO_2$.

2. Non-volatile semiconductor memory cell according to Patent Claim 1, **characterized in that** the floating-gate layer has a poly-Si layer (4a).

3. Non-volatile semiconductor memory cell according to Patent Claim 1 or 2, **characterized in that** the floating-gate layer has a TiN layer or WN layer (4).

4. Non-volatile semiconductor memory cell according to one of Patent Claims 1 to 3, **characterized in that** the layer thickness of the dielectric layer (10) is greater than 15 nm.

5. Non-volatile semiconductor memory cell according to one of Patent Claims 1 to 4, **characterized in that** the layer thickness of the floating-gate layer (4, 4a) lies in a range from 5 nm to 50 nm.

6. Method for fabricating a non-volatile semiconductor memory cell according to one of Patent Claims 1 to 5, comprising the following steps:

   a) forming active regions in a semiconductor substrate (1);
   b) forming a tunnel oxide layer (3);
   c) depositing a floating-gate layer (4);
   d) depositing a metal-containing layer (5) which contains a metal or a metal compound;
   e) etching the metal-containing layer (5) and the floating-gate layer (4);
   f) oxidizing the metal-containing layer (5) and exposed side regions of the floating-gate layer (4) in order to form a dielectric layer (6);
   g) depositing a control-gate layer (7); and
   h) etching the control-gate layer (7), the dielectric layer (6) and the floating-gate layer (4).

7. Method according to Patent Claim 6, **characterized by** the further steps of:

   i) forming an insulating intermediate layer (8) on the surface of the control-gate layer (7).

8. Method according to one of Patent Claims 6 or 7, **characterized in that** in step c) a TiN layer is deposited and in step d) a Ti layer is deposited.

9. Method according to one of Patent Claims 6 or 7, **characterized in that** in step c) a poly-Si layer is deposited and in step d) a $WO_x$ layer, where x = 2 to 3, is deposited.

10. Method according to one of Patent Claims 6 or 7, **characterized in that** in steps c) and d) a common tungsten-containing layer is deposited, and in step f) the oxidizing is carried out until an oxidized partial layer of the tungsten-containing layer forms the dielectric layer (6) and an unoxidized partial layer of the tungsten-containing layer forms the floating-gate layer (4).

**Revendications**

1. Cellule de mémoire à semi-conducteur non volatile comprenant :

   un substrat (1) semi-conducteur ;
   une couche (3) isolante d'oxyde à effet de tunnel ;
   une couche (4) conductrice de grille flottante ;
   une couche (10) isolante diélectrique ; et
   une couche (7) conductrice de grille de commande,

   dans laquelle la couche (10) diélectrique comporte au moins une couche (9a, 9b) en $Si_3N_4$ et une couche (6) d'oxyde métallique en $TiO_2$,
   **caractérisée en ce que** la couche (9a, 9b) en $Si_3N_4$ inclut la couche (6) d'oxyde métallique en $WO_x$, avec x = 2 à 3, et/ou en $TiO_2$.

2. Cellule de mémoire à semi-conducteur non volatile suivant la revendication 1,
   **caractérisée en ce que** la couche de grille flottante comporte une couche (4a) de poly-Si.

3. Cellule de mémoire à semi-conducteur non volatile suivant la revendication 1 ou 2,

**caractérisée en ce que** la couche de grille flottante comporte une couche de TiN ou une couche (4) de WN.

4. Cellule de mémoire à semi-conducteur non volatile suivant l'une des revendications 1 à 3, **caractérisée en ce que** l'épaisseur de la couche (10) diélectrique est plus grande que 15 nm.

5. Cellule de mémoire à semi-conducteur non volatile suivant l'une des revendications 1 à 4, **caractérisée en ce que** l'épaisseur de la couche (4, 4a) de grille flottante est de l'ordre de 5 nm à 50 nm.

6. Procédé de production d'une cellule de mémoire à semi-conducteur non volatile suivant l'une des revendications 1 à 5, comprenant les stades dans lesquels :

   a) on forme des zones actives dans un substrat (1) semi-conducteur ;
   b) on forme une couche (3) d'oxyde à effet de tunnel ;
   c) on dépose une couche (4) de grille flottante ;
   d) on dépose une couche (5) contenant du métal qui contient un métal ou un composé métallique ;
   e) on attaque la couche (5) contenant du métal et la couche (4) de grille flottante ;
   f) on oxyde la couche (5) contenant du métal et des parties latérales mises à nu de la couche (4) de grille flottante pour former une couche (6) diélectrique ;
   g) on dépose une couche (7) de grille de commande ; et
   h) on attaque la couche (7) de grille de commande, la couche (6) diélectrique et la couche (4) de grille flottante.

7. Procédé suivant la revendication 6, **caractérisé par** les stades supplémentaires :

   i) on forme une couche (8) intermédiaire isolante à la surface de la couche (7) de grille de commande.

8. Procédé suivant l'une des revendications 6 ou 7, **caractérisé en ce qu'**au stade c), on dépose une couche de TiN et, au stade d), une couche de Ti.

9. Procédé suivant l'une des revendications 6 ou 7, **caractérisé en ce qu'**au stade c), on dépose une couche de poly-Si et, au stade d), une couche de $WO_x$, avec x = 2 à 3.

10. Procédé suivant l'une des revendications 6 ou 7, **caractérisé en ce qu'**aux stades c) et d), on dépose une couche commune contenant du tungstène et, au stade f), on effectue l'oxydation jusqu'à ce qu'une couche partielle oxydée de la couche contenant du tungstène constitue la couche (6) diélectrique et une couche partielle non oxydée de la couche contenant du tungstène constitue la couche (4) de grille flottante.

## FIG 1a

## FIG 1b

## FIG 1c

FIG 1d

FIG 1e

FIG 1f

## FIG 2

E(eV)

1    3    4    6    8    7

10

## FIG 3

E(eV)

1    3    4    6    7

# FIG 4

E(eV)

1 3 4 4a 8a 6 8b 7

10

# FIG 5

E(eV)

1 3 4 4a 9a 6 9b 7

10

# FIG 6

E(eV)

1    3    4    6    8c    7

10

# FIG 7 Stand der Technik

E(eV)

O    N    O

1s    3s    4s    10o    10n    10o    7

10s

13